(19) Europäisches Patentamt
European Patent Office
Office européen des brevets

(11) **EP 3 206 318 B1**

(12) **EUROPEAN PATENT SPECIFICATION**

(45) Date of publication and mention
of the grant of the patent:
**26.06.2019 Bulletin 2019/26**

(51) Int Cl.:
***H04L 1/00*** *(2006.01)*   ***H04J 13/10*** *(2011.01)*
***H03M 13/00*** *(2006.01)*

(21) Application number: **16305163.4**

(22) Date of filing: **12.02.2016**

(54) **NON-ORTHOGONAL MULTIPLE UPLINK COMMUNICATIONS**

NICHTORTHOGONALE MEHRFACHE UPLINK-KOMMUNIKATIONEN

COMMUNICATIONS DE LIAISON MONTANTE MULTIPLE NON ORTHOGONALE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**16.08.2017 Bulletin 2017/33**

(73) Proprietor: **Alcatel Lucent**
**91620 Nozay (FR)**

(72) Inventors:
• **FANG, Dong**
**15 Dublin (IE)**
• **CLAUSSEN, Holger**
**15 DUBLIN (IE)**

(74) Representative: **Mills, Julia et al**
**Script IP Limited**
**18 Bridge Street**
**Frome Somerset BA11 1BB (GB)**

(56) References cited:
• **NATARAJAN LAKSHMI ET AL: "Lattice Index Coding", IEEE TRANSACTIONS ON INFORMATION THEORY, IEEE PRESS, USA, vol. 61, no. 12, 1 December 2015 (2015-12-01), pages 6505-6525, XP011590106, ISSN: 0018-9448, DOI: 10.1109/TIT.2015.2491924 [retrieved on 2015-11-18]**

• **YU-CHIH HUANG ET AL: "Multistage Compute-and-Forward with Multilevel Lattice Codes Based on Product Constructions", ARXIV.ORG, CORNELL UNIVERSITY LIBRARY, 201 OLIN LIBRARY CORNELL UNIVERSITY ITHACA, NY 14853, 10 January 2014 (2014-01-10), XP080001268,**

• **FORNEY G D ET AL: "SPHERE-BOUND-ACHIEVING COSET CODES AND MULTILEVEL COSET CODES", IEEE TRANSACTIONS ON INFORMATION THEORY, IEEE PRESS, USA, vol. 46, no. 3, 1 May 2000 (2000-05-01), pages 820-850, XP008036453, ISSN: 0018-9448, DOI: 10.1109/18.841165**

• **BOBAK NAZER ET AL: "Compute-and-Forward: Harnessing Interference Through Structured Codes", IEEE TRANSACTIONS ON INFORMATION THEORY, IEEE PRESS, USA, vol. 57, no. 10, 1 October 2011 (2011-10-01), pages 6463-6486, XP011361363, ISSN: 0018-9448, DOI: 10.1109/TIT.2011.2165816**

• **ORDENTLICH OR ET AL: "The Approximate Sum Capacity of the Symmetric Gaussian $K$ -User Interference Channel", IEEE TRANSACTIONS ON INFORMATION THEORY, IEEE PRESS, USA, vol. 60, no. 6, 1 June 2014 (2014-06-01), pages 3450-3482, XP011548344, ISSN: 0018-9448, DOI: 10.1109/TIT.2014.2316136 [retrieved on 2014-05-15]**

**Description**

FIELD OF THE INVENTION

The field of the invention relates to the transmission of uplink signals from multiple users.

BACKGROUND

The 3GPP standardization effort for fifth generation (5G) networks for mobile communication targets unprecedented capacity densities of up to 25 Gbit/s/km$^2$. To this end, new multiple access technique must be developed because current 3G-4G solutions have not been designed to meet such demands.

Currently multiple signals from multiple users are transmitted using orthogonal multiple access (OMA) schemes such as frequency division multiple access (FDMA), time division multiple access (TDMA), code division multiple access (CDMA), and orthogonal frequency division multiple access (OFDMA). These provided reasonable system-level throughput performance in packet-domain services with simple single-user detection.

However, in order to keep the orthogonality among users, OMA sacrifices the spectral efficiency. To this end, to improve the spectral efficiency and meet the capacity requirement of future 5G system, the 3GPP recently initiated discussions on further evolution of LTE where the NTT DoCoMo first proposed the framework of the non-orthogonal multiple access (NOMA).

In NOMA, multiple users are multiplexed in the power-domain at the transmitter side and multi-user signal separation on the receiver side is conducted based on successive interference cancellation (SIC). Thus, users in one cell are served by a base station (BS) with the same time/code/frequency channel, and their signals are multiplexed by using different power allocation coefficients. The novelty of NOMA comes from the fact that users with poorer channel conditions are allocated more transmission power. In this way, these users are able to decode their own messages by treating others' information as noise, since the power level of their own messages is higher. On the other hand, the users with better channel conditions will use the successive interference cancellation (SIC) strategy, i.e., they first decode the messages to the users with poorer channel conditions and then decode their own by removing the other users' information.

Current NOMA schemes have only been considered for downlink transmissions. NOMA in the uplink transmissions is an open problem. Furthermore, current downlink NOMA schemes have not specified which coding scheme is to be used. Moreover, if the conventional SIC decoding is adopted in NOMA, the performance would be degraded significantly due to the severe error propagation among different coding levels.

"Lattice Index Coding" by Natarajan et al., IEEE Transactions on Information Theory Vol 61, No 12 Dec 2015 discloses an encoding scheme for messages broadcast to a plurality of receivers where every receiver demands all the messages, the network being a wireless relay network for example. In one example the encoded messages are weighted prior to broadcast by weighting coefficients that are each formed as a product of distinct primes, each weighting coefficient being formed by excluding a different distinct prime from the product. The combined weighted messages are then broadcast.

Yu-Chih Huang et al " Multistage Compute-and Forward with Multilevel Lattice Codes Based on Product Constructions" discloses multistage coding and decoding schemes using lattice codes.

It would be desirable to improve spectral efficiency in uplink transmissions without unduly increasing interference between signals.

SUMMARY

A first aspect of the present invention provides a method performed at a user equipment as it is defined in claim 1.

The inventor of the present invention recognised that signals transmitted by multiple user equipment to a base station can interfere. Although interference can be reduced by transmitting them in an orthogonal manner, this reduces spectral efficiency and as such the inventors sought a non-orthogonal transmission method which nevertheless allowed the base station to efficiently separate out the transmitted signals. This is achieved by user equipment that map a linear encoded signal to form a lattice code and use a weighting coefficient for that lattice code that is formed as a product of a plurality of primes, each weighting coefficient for each user equipment excluding a different one of said plurality of primes. The use of such weighting coefficients and lattice codes allows a base station receiving the signals to use the modulo lattice operation to extract each user equipment signal in a relatively simple yet efficient manner that thereby allows multiple users to transmit signals in a non-orthogonal way to a base station.

In one example, where n weighting coefficients are formed, these are formed from n distinct primes, each weighting coefficient being formed as a product of n- 1 of the n distinct primes and each weighting coefficient not comprising a different one of the n distinct primes.

The network node selects weighting coefficients for each user equipment and transmits an indication to the user equipment indicating the weighting coefficient to use. By the network node transmitting such an indication the weighting coefficients used by each user equipment can be centrally controlled such that they are all different and each exclude a different prime, allowing different lattice modulo operations to extract individual signals. The indications may comprise the weighting coefficient themselves or they may comprise some other indicator which may indicate which weighting coefficient from a plurality of weighting coefficients, perhaps stored by the user equipment, the user equipment should select.

The network node selects the weighting coefficients for a particular user equipment based on channel quality, as by providing a higher weighting coefficient for users with poorer channel quality the poor channel quality is to some extent mitigated. Thus, the user equipment receives an indication of the channel quality relative to the channel quality of other user equipment from the network node and determines the weighting coefficient in dependence on this.

The indication of channel quality comprises a relative indication, indicating a channel quality of said user equipment in comparison to a channel quality of other user equipment communicating with said base station.

The channel quality indication is a relative indication, for example, it may simply be an index indicating the ranking of the channel quality of that user equipment compared to other user equipment communicating with the network node. This information is useful to the user equipment as it can then select the appropriate weighting coefficient in dependence upon its channel quality related to other user equipment. Provided the other user equipment select their channel coefficients in the same way, the signals can be transmitted efficiently allowing the base station to separate them out. In this regard, the poorer channel qualities are provided with larger coefficients which helps mitigate the interference effects felt by these poorer channels.

In some embodiments, said step of linearly encoding comprises generating a linear code over a finite field.

In some embodiments the linear encoder generates a linear code over a finite field.

In some embodiments, the size of the finite field is linked to the size of the weighting coefficient, a higher weighting coefficient being linked to a smaller finite field.

Encoders encoding over a finite field can be mapped to lattice codes. A smaller finite field transmits less information and is thus suitable for poorer channel quality where it makes sense to transmit less information. The higher weighting coefficient mitigates for the poorer channel quality.

In some embodiments the size of the finite field provides the lattice partition operation, which can determine a distinct prime for each codeword (either the distinct prime and the size of finite field are equal or the absolute value of the square of this distinct prime equals the size of finite field) and in turn this may be used to construct the weighting coefficient for each code layer generated by the encoder, which is formed as a product of the distinct primes excluding the prime of that code layer

In some embodiments, the signal is normalised prior to output to provide a suitable power level prior to outputting the signal from the user equipment.

A second aspect to the present invention provides a user equipment as it is defined in claim 4.

In some embodiments, the indication may be an indication of channel quality, a poorer channel quality indicating a larger coefficient.

In some embodiments, said linear encoder comprises a finite field encoder configured to generate a linear code over a finite field.

In some embodiments, a size of said finite field is linked to a size of said coefficient, a higher coefficient indicating a smaller finite field.

In some embodiments, the user equipment comprises normalising circuitry for normalising a power level of said weighted signal prior to outputting said signal.

A third aspect of the present invention provides a method performed at a network node as it is defined in claim 5.

As noted previously, user equipment transmitting lattice code signals with weighting coefficients that are formed of products of distinct primes each excluding a different prime provide combined signals where the individual elements can be extracted at the network node by using modulo lattice operations based on the excluded prime.

It should be noted that the network node is a node via which the user equipment may communicate with a network, it may for example be a base station, an access point or a hub base station.

The network node receives signals from multiple user equipment and can determine their channel quality. In some cases it may determine the channel quality of each user equipment compared to the channel quality experienced by the other user equipment communicating with the network node. The network node transmits an indication of the weighting coefficients to each of the multiple user equipment who can use it to determine their coefficient for weighting their signal and in some cases for selecting the order of the finite field used by the encoder. As the weighting coefficient is dependent on the channel quality the indication of the weighting coefficient may be an indication of the channel quality.

In some embodiments, the method comprises determining a modulo lattice operation to perform in order to extract each user equipment signal in dependence upon said weighting coefficient used by said user equipment.

As noted, the channel quality will determine the weighting coefficient used by the user equipment and this weighting coefficient determines which modulo operation is required to extract that particular signal.

In some embodiments, the method comprises an initial step of scaling said received signal by a scale factor, said scale factor being selected so as to reduce noise by approximating said scaled coefficients to integers and rounding said channels embedded in said signal into one of integers or complex integers where each rounded integer is relatively prime to a distinct prime associated with the corresponding user's codeword.

In order to increase the accuracy of the decoding, the received signal can be scaled by a factor. This is done to compensate for the different losses that occur due to transmission through the different channels. The channel losses of each channel can be estimated from the strength of certain known signals received from the user equipment and the network node can estimate the expected effect of these channel losses on the signals received and can use this to help estimate the scale factor. The scale factor is chosen so that the coefficients of each user equipment's lattice codeword are close to integers. Furthermore, further scaling is performed to round the channels embedded in the signal into approximate integers or complex integers where each rounded integer is relatively prime to the distinct prime associated with the corresponding user's codeword, that is relatively prime to the distinct prime excluded from said corresponding weighting coefficient product.

In some embodiments, the method comprises extracting a plurality of said user equipment signals by performing a plurality of modulo lattice operations on said received signal; and decoding said extracted signals.

Generally a network node will need to decode all received user equipment signals. A plurality of modulo lattice operations can be performed on the received signal to extract each signal. In this regard, where latency is important, these can be performed in parallel. However, performing them in parallel will have interference issues and the quality will be reduced. Thus, in some embodiments the method comprises performing at least some of said plurality of modulo lattice operations on said received signal in series; wherein prior to performing a subsequent modulo lattice operation in said series of modulo lattice operations, performing the steps of: reconstructing a weighted lattice coded signal from a previously extracted decoded signal; subtracting said reconstructed signal from said received signal to form a resultant signal; performing said subsequent modulo lattice operation on said resultant signal to extract a further weighted lattice coded signal; and decoding said extracted signal.

By performing the modulo lattice operations in series, the errors from the first extracted signal can be deducted from the overall signal and thus, the next signal will not suffer from those errors and in this way, one in effect gets successive interference cancellation and the output signals have an improved quality.

Although this can be performed in any order, it is advantageous if it is formed in an order that is dependent on the channel quality, such that the poorer channels' signal extraction is performed earlier than those transmitted on the stronger channel. In this way, the channels where the errors are likely to be the highest are extracted from the signals with the errors themselves compensated for by the decoding.

In some embodiments, the method comprises determining at least one of a required latency and quality requirement of said received signals and in dependence upon said determined at least one of said quality and latency, determining whether to extract said signals by performing said modulo lattice and decoding operations in parallel or in series.

A fourth aspect of the present invention provides a network node as it is defined in claim 12.

In some embodiments, the network node comprises determining circuitry for determining a modulo lattice operation to perform in order to extract each user equipment signal in dependence upon said weighting coefficient used by said user equipment.

In some embodiments, the network node comprises scaling circuitry for scaling said received signal by a scale factor, said scale factor being selected so as to reduce noise by approximating said coefficients to integers and rounding said channels embedded in said signal into one of integers or complex integers where each rounded integer is relatively prime to the distinct prime associated with the corresponding user's codeword.

In some embodiments, the network node comprises a plurality of signal extractors for extracting said user equipment signals by performing a plurality of modulo lattice operations on said received signal; and a plurality of decoders for decoding said extracted signals.

In some embodiments said plurality of signal extractors and decoders are arranged in series, while in other embodiments they are arranged in parallel.

In embodiments where said plurality of signal extractors and decoders are arranged in series, said network node further comprises a plurality of signal reconstructors and subtractors arranged in series between said decoders and signal extractors, such that said signal reconstructors reconstruct a weighted lattice coded signal from a previously extracted decoded signal and a subsequent signal subtractor subtracts said reconstructed signal from a signal input to said previous signal extractor to form a resultant signal said resultant signal being routed to a subsequent signal extractor.

By performing the modulo lattice operations in series, the errors from the first extracted signal can be deducted from the overall signal and thus, the next signal will not suffer from those errors and in this way, one in effect gets successive interference cancellation and the output signals have an improved quality.

Although this can be performed in any order, it is advantageous if it is formed in an order that is dependent on the channel quality, such that the poorer channels' signal extraction is performed earlier than those transmitted on the stronger channel. In this way, the channels where the errors are likely to be the highest are extracted from the signals with the errors themselves compensated for by the decoding.

In some embodiments, the network node further comprises control circuitry for determining at least one of a required latency and quality requirement of said received signals and in dependence upon said determined at least one of said quality and latency, connecting said plurality of signal extractors and decoders in parallel or series.

As noted above the network node can in some embodiments be dynamically configured to extract the signals in parallel or in series depending on the required latency or quality.

A fifth aspect of the present invention provide a computer program which when executed by a computer is operable to control said computer to performs steps in a method according to one of a first or third aspect of the present invention.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

BRIEF DESCRIPTION OF THE DRAWINGS

Embodiments of the present invention will now be described further, with reference to the accompanying drawings, in which:

Figure 1 illustrates performance comparison between the uplink LPMA of embodiments and the conventional OMA;
Figure 2 provides a schematic illustration of a lattice partition non orthogonal multiple access (LPMA) communication system with successive interference cancellation at the network node according to an embodiment;
Figure 3 provides a schematic illustration of a proposed lattice partition non orthogonal multiple access (LPMA) communication system with parallel signal extraction and decoding at the network node;
Figure 4 provides a schematic illustration of a coding and modulation procedure performed at a user equipment according to an embodiment;
Figure 5 provides a schematic illustration of series signal extraction decoding at a network node according to an embodiment;
Figure 6 provides a schematic illustration of parallel signal extraction and decoding at a network node according to an embodiment;
Figure 7 provides a flow diagram illustrating steps of a method performed at a user equipment according to an embodiment; and
Figure 8 provides a flow diagram illustrating steps of a method performed at a network node according to an embodiment

DESCRIPTION OF THE EMBODIMENTS

Before discussing the embodiments in any more detail, first an overview will be provided.

Motivated by the above challenges of NOMA, embodiments seek to provide a new NOMA for the uplink 5G multiple access, which exploits the structural property of lattice codes for multiplexing the users. The proposed LPMA significantly enhances the performance in terms of spectral efficiency over the current uplink orthogonal multiple access schemes (TDMA/FDMA/CDMA/OFDMA).

This technique, which we refer to as the uplink lattice partition multiple access (uplink LPMA), addresses the main issues of existing solutions by

(1) facilitating the uplink multiple access in a non-orthogonal pattern;
(2) exploiting the structural properties of lattice for multiplexing the users;
(3) providing a new successive interference cancellation (SIC)/parallel interference cancellation (PIC) decoding method, which has a superior performance over the conventional SIC/PIC decoding when applied in NOMA

In particular, it is proposed to

- use the lattice partition method as the new non-orthogonal multiple access design in the uplink, i.e., the multiple users are multiplexed by the different lattice partitions (different coarse lattices over the same fine lattice);
- multiplex users by different lattice partitions, where the size of the lattice partitions are determined by the different primes. Prior to transmitting, each UE multiplies its lattice codes by a weighting coefficient which is a product of distinct primes and comprises one distinct prime not comprised in the products forming other weighting coefficients;

- round the channels into integers or complex integers where each rounded integer is relatively prime to the distinct prime associated with the corresponding user's codeword. such that the lattice partition can multiplex the users by using the modulo lattice operation; on the other hand, this rounding function also guarantees maximizing the sum-rate of all UEs;

- decode the signal of each UE by using the modulo operation and SIC/ PIC. As the primes for the lattice partitions of all UEs are relatively prime to each other, the modulo for a specific prime can keep its corresponding UE's signal but directly cancel out the other UEs' signals. The proposed modulo lattice operation with SIC (MLO-SIC) can enhance the performance while in the latency sensitive scenario, the proposed modulo lattice operation with PIC (MLO-PIC) reduces the decoding latency.

The benefits of the above technique features can be summarized as follows:

- using the lattice partition to multiplex UEs utilizes the structural properties of lattice codes which suppresses the co-channel interference;

- the proposed encoding method results in a straightforward power allocation scheme for each UE and makes the UE extract their desired signal easily;

- the proposed decoding method has a linear decoding complexity which is only bounded by the UE with the largest size of lattice partition. More specifically, the decoding complexity of the proposed LPMA does not exponentially increase with the number of UEs.

- the proposed LPMA shows a superior performance in terms of the spectral efficiency over the conventional uplink OMA such as TDMA/ FDMA/ CDMA/ OFDMA. Compared with the current OMA, our proposed uplink LPMA enhances the user throughput from 55Mbps to 91bps.

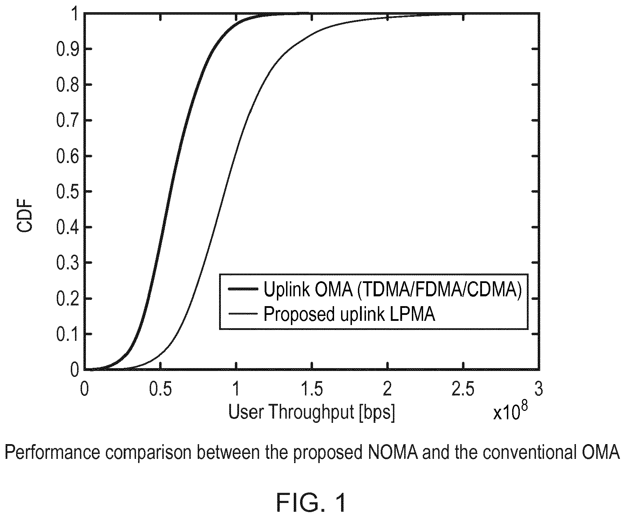

These results can be seen in Fig. 1.

Fig. 1 shows the comparison of user throughput between the proposed **LPMA** (uplink LPMA) and the conventional OMA (TMDA/ FDMA/ CDMA/ OFDMA).

The simulation parameters are given in the following table:

Table 1: The parameters of simulation

| Cellular Layout: | Hexagonal, wrapped around |
|---|---|
| Topology | 7 sites (no sectorization) |
| Bandwidth | 10Mhz |
| Tx/Rx Antenna No. | 1 (omni-directional) |
| No. of UE per cell | 2 (under the same resources) |
| BS-to-BS distance | 500m |
| Channels | i.i.d Rayleigh fading |
| UE Tx power | 23dBm |
| Thermal noise density | -174dBm/Hz |
| Rx Noise figure | 5dB |
| Path loss model | $21.5 + 36.7 * \log 100(D)$, $D$ in km |

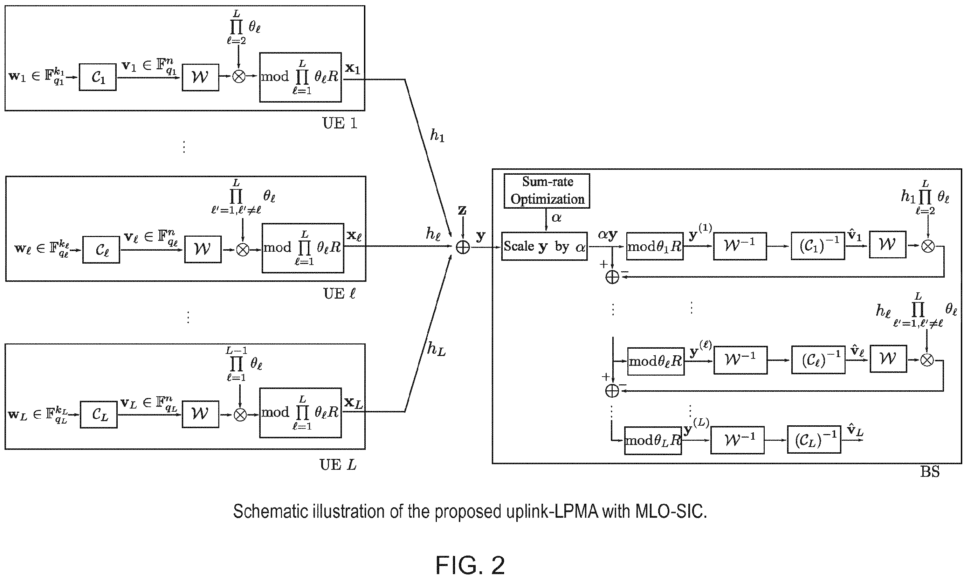

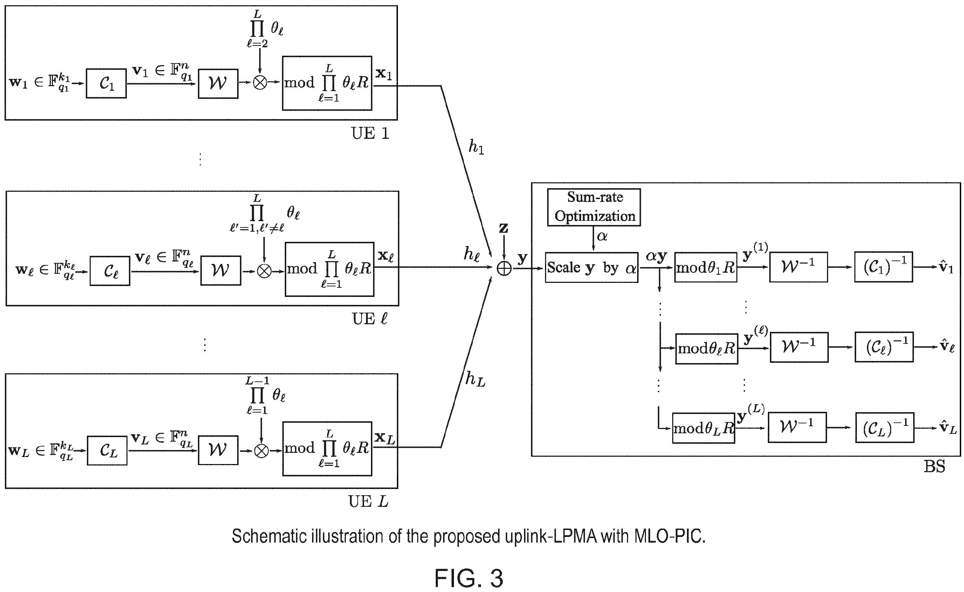

The concept and its benefits are described in more detail below. First, we introduce the following notation for easy of reading of Figs. 2 and 3.

Table 2: Notations of Figs. 2 and 3

| Notations | Physical Meanings |
|---|---|
| $\mathbf{w}_\ell$ | UE $\ell$'s signal |
| $C_\ell$ | The FEC encoder for UE $\ell$ |
| $\mathbf{v}_\ell$ | The codeword generated from $\mathbf{w}_\ell$ |

6

(continued)

| Notations | Physical Meanings |
|---|---|
| $F_{q_\ell}$ | The finite field with size $q_\ell$ where $q_\ell$ should be a prime |
| $k_\ell$ | The length of $\mathbf{w}_\ell$ |
| $n$ | The length of the resulted codeword |
| $\theta_\ell$ | The distinct prime for codeword $\ell$ (for UE $\ell$) |
| $R$ | The dimension-wise element of a lattice codeword. The details of constructing $R$ are shown in the following section. |
| $(C_\ell)^{-1}$ | The FEC decoder for UE $\ell$ |
| $\alpha$ | The scale factor for the received signal |

The abstract system structure of the proposed LPMA can be seen in Figs. 2 and 3 with MLO-SIC and MLO-PIC decoding methods, respectively.

Figure 2 shows each user equipment comprising a linear encoder C, mapping circuitry W, a multiplier for multiplying by a selected weighting coefficient and circuitry for applying a normalising function. The encoder C is a linear encoder which generates codewords over a particular finite field. The size of the finite field is selected in dependence upon the channel quality for that user equipment. In this regard, the user equipment will receive an indication from the base station which will rank its channel quality compared to other user equipment. From this it can select a coefficient for weighting the signal and a finite field size for the encoder. The finite field sizes are relatively prime with respect to each other. In some embodiments, the user equipment stores a list of possible weighting coefficients and corresponding finite fields and the indication will indicate to the user equipment which one to select. In other embodiments the indicator will more directly provide information regarding the weighting coefficient. A signal that is to be transmitted is then encoded by the encoder over the particular finite field and is mapped to a lattice code by the mapping circuitry. This encoded signal is then weighted by the selected weighting coefficient and it is normalised such that the power is suitable for output. This encoded weighted signal is then output. User equipment with poorer channels will select larger weighting coefficients and smaller finite fields. An encoder encoding over a smaller finite field will transmit less information while a higher weighting coefficient will mitigate for losses due to the poorer channel.

Other user equipment within the cell of the base station encode and map their signals in a similar manner, the finite field of the encoder and the weighting coefficient being selected in dependence upon the relative channel strength experienced by that user equipment. Each user equipment uses a different weighting coefficient and a different finite field. This allows the base station that receives these signals to extract individual signal by using lattice modulo operations appropriate for a particular user equipment.

The base station comprises signal extractors for demultiplexing the combined signals and extracting each of the individual user equipment signals. These signal extractors extract individual signals by performing lattice modulo operations on a combined signal, the lattice modulo operation performed to extract a particular signal depending on the excluded prime of the weighting coefficient used to weight that signal. The signal extractor circuitry can be arranged in parallel as is shown in Figure 3 and can extract the signals in parallel whereupon they can be mapped back to a linear code and decoded, or they can be arranged in series as is shown in Figure 2. The series arrangement allows successive interference cancellation to be performed which reduces errors but increases latency. Where the signal extractor circuits are arranged in series, it is advantageous if the signal transmitted via the poorest channel is extracted first and once it has been decoded, it is then reconstructed to its lattice code form and subtracted from the signal. In this way, errors associated with the signal from the poorest channel are removed or at least reduced in the total signal and the resultant signal which has had this signal extracted from it along with the errors associated with it, can then have the signal with the next highest weighting coefficient extracted from it by using a lattice modulo operation appropriate for that weighting coefficient. In this way, there is successive interference cancellation and although there is increased latency, the signals that are decoded are of a higher quality.

It should be noted that this combined signal is received from individual user equipment with different channel losses which are denoted in the figures as h. Channel losses from each user equipment can be estimated from known signals transmitted between the network node and the user equipment, and these estimated losses can be used to generate scale factors to reduce the noise by tending each weighting coefficient towards an integer. The channel signals embedded in the combined signal are then rounded integers or complex integers where each rounded integer is relatively prime to the distinct prime associated with the corresponding user's codeword, prior to be extracted by a modulo prime operation. Reduction of the noise is important as it allows the modulo lattice operation to be successfully performed.

Based on these figures, we can summarize the advantages of the proposed approach:

**Using lattice partitions to multiplex users.**

The proposed LPMA adopts a multi-dimensional lattice constellation. Based on the channel quality feedback from BS, $L$ UEs transmit their weighted lattice codes over the finite fields $F_{q_1},...,F_{q_\ell},...,F_{qL}$, respectively. The weighted coefficients assigned to UEs are the primes from some special algebraic structure, e.g., the integers, Gaussian or Eisenstein integers and each exclude a different prime. As such, by taking a simple modulo lattice operation, each lattice code can be extracted and decoded to obtain the UE's desired signal. This facilitates BS to implement SIC/ PIC with modulo lattice operation as their decoding pattern and hence achieves a relatively low decoding complexity. On the other hand, in order to keep the user fairness, the weighted coefficients for the weak users are larger than those for the strong users.

**Facilitating the decoding by rounding channels into integers**

Note that after experiencing the fading, the received signal is actually formed as the complex combination of lattice codewords due to the different losses over the different channels and hence cannot be used to separate the user signals using modulo lattice operation without some error. In order to facilitate the modulo lattice operation and lattice decoding, the received signal is scaled by a factor and the channels embedded in it are rounded into integers or complex integers where each rounded integer is relatively prime to the distinct prime associated with the corresponding user. A sum-rate optimization is implemented for selecting the appropriate scaling factor and primes (as seen in Figs. 2 and 3).

**Decoding using modulo operation and SIC/PIC**

Recall that the coefficients of each UE's lattice codewords each exclude different primes compared to each other. After taking modulo lattice operation and lattice decoding, each UE's desired signal can be separated. Based on this, it is implied that the SIC decoding paradigm can be adopted. That is, following modulo lattice operation (see Fig. 2) and lattice decoding, the decoded UE's signal is used to reconstruct the lattice codeword, which will be subtracted from the received signal before decoding the other UE's signals. As such, decoding complexity is only bounded by the UE with the largest size of lattice partition (the decoding complexity of the proposed uplink LPMA does not exponentially increase with the number of UEs). For the case where the decoding latency is sensitive, we propose the modulo lattice operation with parallel interference cancellation (MLO-PIC) for multiplexing users, where in each decoding branch, the modulo lattice operation first cancels out the interference for that signal and the followed decoder extracts the desired signals (see Fig. 3).

The following text explains in more detail the above-mentioned aspects of the proposed invention.

**Preliminaries: the concepts of lattice codes**

Let C denote the complex domain. Let $R \subset$ C be a principal ideal domain (PID) [1], which is a commutative ring such that: (1) whenever $ab = 0$ for $a,b \in R$, either $a = 0$ or $b = 0$; (2) $aR = \{ar: r \in R\}$ for some $a \in R$ can be used to represent the ideal in $R$, where ideal means a set of elements in $R$ that is closed under addition and multiplication by an arbitrary element in $R$. The most widely-used $R$s are: 1) the ring of integers Z ; 2) the ring of Gaussian integers Z[$i$], where Z[$i$]={$a+bj$:$a,b \in$ Z}; and 3) the ring of Eisenstein integers Z[$\omega$], where Z[$\omega$]={$a+b\omega$:$a,b \in$ Z} and $\omega = \dfrac{-1+\sqrt{3}}{2}$.

**Definition 1** ($R$-Lattice) [1]. Let $N \leq n$. A subset $\Lambda$, is a set of C$^n$ is called an $N$ - dimensional $R$ -lattice if it forms a $R$ -module of rank $N$, that is, $\Lambda$ is closed under addition and multiplication by scalars in the ring $R$, and there are $N$ linearly independent vectors $\mathbf{t}_1,...\mathbf{t}_N \in \Lambda$ such that

$$\Lambda = \left\{ \sum_{j=1}^{N} r_j \mathbf{t}_j, r_j \in R, \forall j \right\}.$$

A lattice $\Lambda$ has the following prosperities: if $\mathbf{x}, \mathbf{y} \in \Lambda$, then $\mathbf{x+y} \in \Lambda$ ; and if $\mathbf{x} \in \Lambda$, then $-\mathbf{x} \in \Lambda$. A subset $\Lambda'$ of $\Lambda$ is called a sub-lattice of $\Lambda$ if it is a $R$-module.

Given a $R$-Lattice $\Lambda$ and a sub-lattice $\Lambda'$ of $\Lambda$, the quotient group $\Lambda'/\Lambda = \{\lambda + \Lambda' : \lambda \in \Lambda\}$ of $\Lambda$ naturally forms a partition of $\Lambda$.

**Definition 2** (Lattice Quantizer) [1]. For a $\mathbf{x} \in$ C$^n$, the nearest neighbour quantizer associated with $\Lambda$ is denoted as

$$Q_\Lambda(\mathbf{x}) = \lambda \in \Lambda; \|\mathbf{x} - \lambda\| \leq \|\mathbf{x} - \lambda'\|, \forall \lambda' \in \Lambda,$$

where $\|\cdot\|$ represents the norm operation.

**Definition 3** (Modulo Operation) [1]. The modA operation returns the quantization error with respect to A and is represented as

$$\mathbf{x} \bmod \Lambda = \mathbf{x} - Q_{\Lambda}(\mathbf{x}).$$

**The proposed LPMA**

Transmission of lattice codeword at UE side

Let $\theta$ be a prime from $R$, with $\theta$ being the product of a unit, a rational prime $q$ and $|\theta|^2 = q$. There naturally exists a quotient ring $R/\theta R$ with the order $|R/\theta R| = |\theta|^2 = q$ and hence $R/\theta R \cong F_q$. This indicates a mapping relationship:

$$\pi : R \xrightarrow{\bmod \theta R} R / \theta R \underset{\mathcal{W}}{\overset{\mathcal{W}^{-1}}{\rightleftarrows}} \mathbb{F}_q$$

where W is a ring isomorphism which is used as the mapping function in the proposed approach, given by

$$\mathrm{W} \doteq \mathrm{F}_q \rightarrow R / \theta R .$$

**Definition 4** (Construction A) [1]. Let $n$ and $k$ be integers, where $n \leq k$ and let **G** be a generator matrix of an ($n$, $k$) linear code over $F_q$. Construction A consists of the following steps:

1) Define the discrete codebook $C_{\ell} = \left\{ \mathbf{v}_{\ell} = \mathbf{G} \otimes \mathbf{w}_{\ell} : \mathbf{w}_{\ell} \in F_q^k \right\}$, $\forall \ell \in \{1,...,L\}$ where all operations are over $F_q$.

2) Construct $\Lambda^* = \mathrm{W}(C_{\ell})$, where

$$\mathrm{W} \doteq \mathrm{F}_q \rightarrow R / \theta R$$

is a ring isomorphism.

3) Tile $\Lambda^*$ to the entire $R^n$ to form $\Lambda = \theta R^n + \Lambda^*$. It can be shown that a real vector $\lambda$ belongs to $\Lambda$ if and only if $\sigma(\lambda) \in C$ where

$$\sigma \triangleq \mathcal{W}^{-1} \circ \bmod \theta R$$

is a ring homomorphism.

The complex signals transmitted over channel is represented as

$$\mathbf{x}_{\ell} = \left[ \mathrm{W}(\mathbf{v}_{\ell}) \prod_{\ell'=1, \ell' \neq \ell}^{L} \theta_{\ell'} \right] \bmod \prod_{\ell=1}^{L} \theta_{\ell} R$$

where the operation of multiplying the resulted lattice codeword

$$\mathrm{W}(\mathbf{v}_{\ell})$$

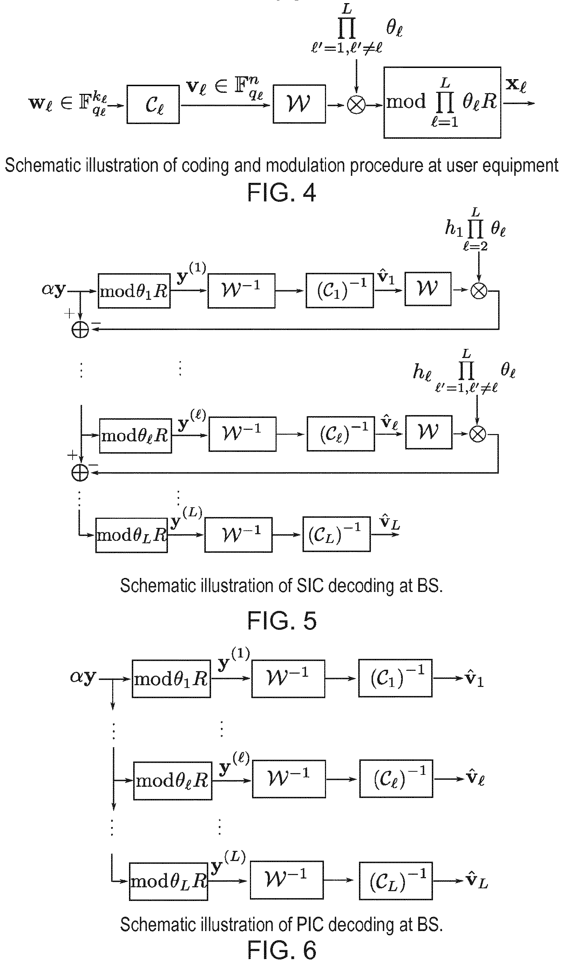

by $\prod_{\ell'=1,\ell'\neq\ell}^{L}\theta_{\ell'}$ aims at: 1) scaling the resulted lattice codeword; 2) facilitating $\mathrm{mod}\,\theta_\ell R$ mod operation to separate each UE $\ell$'s message. The above coding and modulation procedure can be seen in Fig. 4.

Reception of lattice SC codeword at BS side

Suppose that BS are serving $L$ UEs such that the superimposed signal at BS can be virtually presented as

$$\mathbf{y} = \sum_{\ell=1}^{L} h_\ell \mathbf{x}_\ell + \mathbf{z} \, ,$$

where the transmitted lattice codeword $\mathbf{x}_\ell$ is with dimension $n$ and power $P_\ell$; $h_\ell$ is the channel coefficient from UE $\ell$ to BS; and $\mathbf{z} \sim CN(0,\sigma^2 \mathbf{I}^n)$ is the noise.

In order to form the linear combination of lattice codewords, BS first scales the received signal $\mathbf{y}$ by a factor $\alpha$ and expands the scaled signal as

$$\alpha\mathbf{y} = \sum_{\ell=1}^{L} a_\ell \mathbf{x}_\ell + \underbrace{\sum_{\ell=1}^{L} \left(\alpha h_\ell - a_\ell\right)\mathbf{x}_\ell + \alpha\mathbf{z}}_{\mathbf{z}_{\mathrm{eff}}} \, ,$$

where $a_\ell$ is the integer coefficient after rounding over channels and its selection criterion is given in the following paragraph; $\mathbf{z}_{\mathrm{eff}}$ represents the effective noise which contains the fraction parts after rounding and the additive white Gaussian noise.

Substituting the expression of $\mathbf{x}_\ell$ into $\mathbf{y}$, the above scaled received signal can be rewritten as

$$\alpha\mathbf{y} = \sum_{\ell=1}^{L} a_\ell \cdot \left[ \mathrm{W}(\mathbf{c}_\ell) \prod_{\ell'=1,\ell'\neq\ell}^{L} \theta_{\ell'} \right] \mathrm{mod} \prod_{\ell=1}^{L} \theta_\ell R + \mathbf{z}_{\mathrm{eff}} \, .$$

where the optimal scaling factor $\alpha$ is obtained from the MMSE criterion such that the variance of the effective noise can be minimized, given by

$$\alpha_{\mathrm{opt}} = \frac{\mathbf{h}^H \mathbf{a} P}{\|\mathbf{h}\|^2 P + \sigma^2} \, ,$$

where $P$ is the power of transmitted codeword; the coefficient vector $\mathbf{a} = [a_1,...,a_L]$ is determined by maximizing the virtual rate of $\sum_{\ell=1}^{L} a_\ell \mathbf{x}_\ell$ and the decidability of each UE's message, given by

$$R(\mathbf{h},\mathbf{a}) = \max_{\mathbf{a}\in Z^2} \log_2 \left( \frac{P}{\|\alpha_{\mathrm{opt}}\mathbf{h} - \mathbf{a}\|^2 P + |\alpha_{\mathrm{opt}}|\sigma^2} \right),$$

s.t.

$$\mathrm{gcd}\left[ a_\ell \cdot \prod_{\ell'=1,\ell'\neq\ell}^{L} \theta_{\ell'}, \quad a_j \cdot \prod_{j'=1,j'\neq j}^{L} \theta_{j'} \right] = 1, \qquad ,$$

$\forall \ell, j \in \{1,...,L\}$ where $\mathrm{gcd}[\cdot,\cdot]$ represents the greatest common divisor.

Substituting $\alpha_{\mathrm{opt}}$ into the above equation results in:

$$R\left(\mathbf{h},\mathbf{a}\right) = \max_{\mathbf{a}\in Z^2}\log_2\left(\frac{P}{\mathbf{aMa}^H}\right),$$

$$\mathbf{M} = \frac{P}{\sigma^2}\mathbf{I}_L - \frac{P^2\mathbf{hh}^H}{\left(\sigma^4 + \sigma^2 P\|\mathbf{h}\|^2\right)}.$$

where                                                                Formally, let $\mathbf{M} = \mathbf{LL}^H$ be the Cholesky decomposition of $\mathbf{M}$, where $\mathbf{L}$ is some lower triangular matrix. (The existence of $\mathbf{L}$ follows from the fact that $\mathbf{M}$ is Hermitian and positive-definite.) Clearly, $\mathbf{aMa}^H$ = $\|\mathbf{aL}\|^2$. Hence, the above rate optimization is equivalent to finding the following shortest vector problem:

$$\mathbf{a}_{opt} = \arg\min_{\mathbf{a}\in R, \mathbf{a}\neq\mathbf{0}}\|\mathbf{aL}\|^2$$

s.t.

$$\gcd\left[a_\ell, \theta_\ell\right] = 1,$$

$\forall \ell \in \{1,...,L\}$ where $\mathbf{a}_{opt}$ represents the returned optimal rounding coefficients. The above shortest vector problem can be easily solved by the conventional lattice reduction algorithm, e.g., Lenstra-Lenstra-Lovász lattice basis reduction algorithm.

After obtaining $\mathbf{a}_{opt}$, BS can implement the modulo lattice and SIC decoding. Here we assume that the order of channel conditions is: UE 1<UE 2<...<UE $L$ and hence based on the SIC decoding principle, BS will take the full SIC decoding for extracting the desired signals from UE 1 to UE $L$. In the following, we will explain the principle of SIC based on module operation for the proposed uplink LPMA.

One can observe that in the mapping function W=, $\theta_1$ appears as the coefficient of every UE's lattice codeword except from the first UE 1. Note that all the $\theta_\ell$ s are relatively prime. Hence, when decoding the first codeword one can first knock out the contribution from all the other UEs' codewords by simply forming

$$\mathbf{y}^{(1)} = \alpha_1\mathbf{y}_1 \bmod \theta_1 R$$

The decoder then decodes the UE 1's signals from $\mathbf{y}^{(1)}$, denoted by $\hat{\mathbf{v}}_1$. For the levels $\ell \in \{2,...,L$ - $1\}$, the decoder subtracts all the interference from the previous levels and knocks out all the contributions from the next levels via forming

$$\mathbf{y}^{(\ell)} = \left[\alpha_\ell\mathbf{y}_\ell - \sum_{s=1}^{\ell-1} a_s\left(W(\hat{\mathbf{v}}_s)\prod_{s'=1,s'\neq s}^{L}\theta_{s'}\right)\right]\bmod \theta_\ell R.$$

The decoder then forms $\hat{\mathbf{v}}_\ell$, the output of the decoder at the $\ell$ -th level, from $\mathbf{y}^{(\ell)}$. This makes the channel experienced by the $\ell$ -th coded stream a single level additive mod $\theta_\ell R$ channel. The above procedure will cause sub-optimality only in the low SNR regime. In the last level of decoding, one does not have to do the modulo operation as there is only one level left. Therefore, the decoder at the last level directly decodes $\hat{\mathbf{v}}_L$ from

$$\mathbf{y}^{(L)} = \left[\alpha_L\mathbf{y}_L - \sum_{s=1}^{L-1} a_s\left(W(\hat{\mathbf{v}}_s)\prod_{s'=1,s'\neq s}^{L}\theta_{s'}\right)\right]\bmod \theta_L R.$$

We summarize the procedure of the SIC decoder with module operation in Fig. 5.
In some scenarios, the decoding latency is a sensitive issue. To reduce the decoding latency, the modulo lattice operation with parallel interference cancellation (MLO-PIC) is proposed for uplink LPMA (as seen in Fig. 6). As all the $\theta_\ell$ s are relatively prime. Hence, when separate each UE's signal, one can first knock out the contribution from all the other UEs' codewords by simply forming

$$\mathbf{y}^{(\ell)} \; = \; \alpha_\ell \mathbf{y}_\ell \; \mathrm{mod} \; \theta_\ell R$$

Then, feeding $\mathbf{y}^{(\ell)}$ into the decoder to extract the message from $\hat{\mathbf{v}}_\ell$.

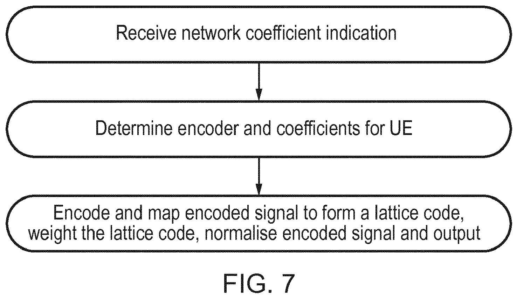

Figure 7 shows a flow diagram illustrating steps in a method performed at a user equipment. A weighting coefficient indicator is received from the network node which indicates a weighting coefficient to be applied to a lattice coded signal. Form this indication the UE determines the actual weighting coefficient and the order of the finite field to be used in the encoder. It then encodes the signal, maps it to a lattice code, weights it with the coefficient and normalises the signal and outputs it.

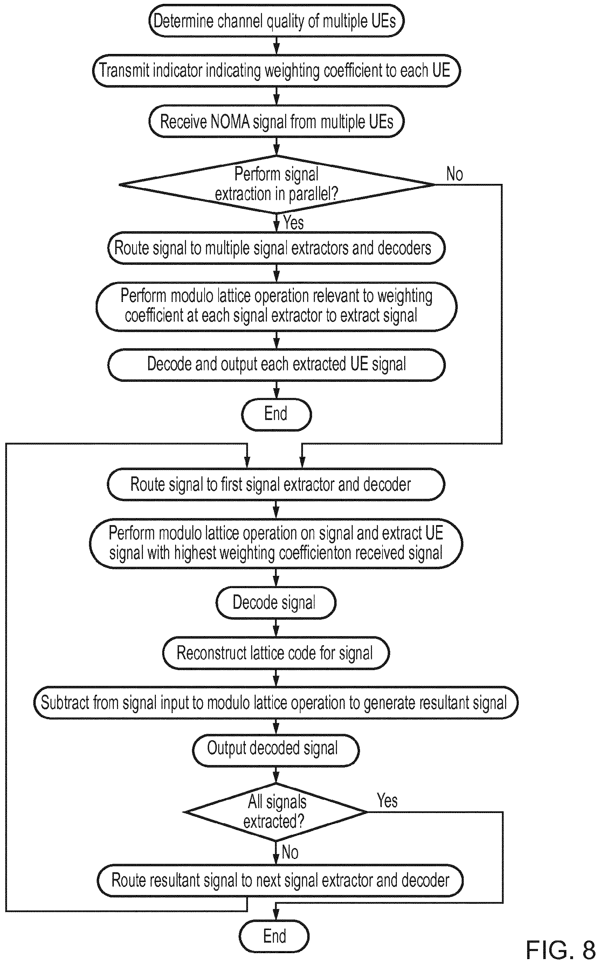

Figure 8 shows a flow diagram illustrating steps performed in a method at the network node. Initially the network node determines the channel quality of multiple UEs communicating with it and from this it determines a channel quality ranking for the UEs and transmits an indication of the weighting coefficients that each UE should use. The UEs with the poorer channels have higher weighting coefficients. All weighting coefficients are different and each excludes a different distinct prime from the product that forms it. An order of the finite field encoder can be also deduced from this indicator as the weighting coefficients and finite field orders are related, lower order finite fields being used for poorer channels. The finite field order are relatively prime with respect to each other and in some embodiments the order of the finite field is the distinct prime excluded from the weighting coefficient.

The network node then receives signals from each UE where the encoded signals are weighted with the weighting coefficients indicated by the network node. The next step (not shown) is to perform channel compensation to compensate for the different losses experienced by the signals transmitted down the different channels. These losses are estimated based on known signals received from the UEs on these channels and a scale factor is determined by sum-rate optimisation to tend the channel coefficients towards integers. The channels embedded in the signal are then rounded into integers or complex integers. Each rounded integer is relatively prime to the distinct prime of the codeword of the corresponding user.

The network node then determines whether to perform signal extraction in parallel or in series on this scaled signal. This is decided in dependence upon the required quality and/or latency, where low latency is required the signals are extracted and decoded in parallel, where when high quality is more important this extraction and decoding is performed in series, which allows successive interference cancellation.

Where parallel signal extraction is selected the signal is routed to multiple signal extractors and their decoders arranged in parallel. Each signal extractor performs a modulo lattice operation relevant to that signal, and the extracted signal is then reverse mapped from the lattice code domain and decoded.

Where series signal extraction is selected then the signal is routed to a first signal extractor, extracted, mapped and then decoded and that signal is output. The decoded signal is also input to a lattice code signal reconstructor to reconstruct the lattice code for that signal with error correction having been performed and the reconstructed signal is subtracted from the combined received signal and the resultant signal is input to a subsequent, signal extractor and decoder and so on until all signals have been extracted and decoded. By performing them in this successive manner, interference can be cancelled or at least reduced at each stage and the quality of the extracted signals for the stronger channels is increased.

Embodiments propose a new non-orthogonal multiple access scheme, called lattice partition based non-orthogonal multiple access (LPMA). It adopts the Construction A based lattice as the basis for the data encoding and medium access and the UEs are multiplexed by different lattice partitions. The resulting solution significantly increases spectral efficiency while retaining a linear computational complexity scaling which does not grow exponentially with the number of UEs.

As seen in Fig. 1, the proposed LPMA shows a significantly improved performance in terms of the spectral efficiency over the conventional uplink OMA such as TDMA/FDMA/CDMA/OFDMA. Compared with the current OMA, our proposed LPMA enhances the user throughput from 55Mbps to 91bps.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

**Claims**

1.    A method performed at a user equipment comprising:

   receiving an indication of a weighting coefficient from a network node, said indication comprising a relative indication indicating a channel quality of said user equipment in comparison to a channel quality of other user equipments communicating with said network node;
   selecting a weighting coefficient from a plurality of stored weighting coefficients to weight a codeword of a lattice code, said plurality of stored weighting coefficients each being formed as a product of distinct primes, each weighting coefficient being formed by excluding a different distinct prime from said product, wherein the weighting coefficient is selected depending on said received indication such that the user equipment when having poorer channels is being provided with higher weighting coefficients;
   linearly encoding a signal for transmission to said network node;
   mapping said linearly encoded signal to form a lattice code;
   weighting said codeword of said lattice code with said selected weighting coefficient; and
   transmitting said weighted encoded signal to said network node.

2.    A method performed at a user equipment according to claim 1, wherein said step of linearly encoding comprises generating a linear code over a finite field.

3.    A method performed at a user equipment according to claim 2, wherein a size of said finite field is linked to a size of said weighting coefficient, a higher weighting coefficient indicating a smaller finite field.

4.    A user equipment comprising:

   a receiver for receiving an indication of a weighting coefficient from a network node, said indication comprising a relative indication indicating a channel quality of said user equipment in comparison to a channel quality of other user equipments communicating with said network node;
   a linear encoder for encoding a signal for transmission to a network node;
   mapping circuitry configured to map said linearly encoded signal to form a lattice code;
   a data store for storing a plurality of weighting coefficients said plurality of weighting coefficients each being formed as a product of distinct primes, each weighting coefficient being formed by excluding a different distinct prime from said product;
   determining circuitry operable to select one of said plurality of weighting coefficients from said stored weighting coefficients to weight a codeword of said lattice code in dependence upon said received indication, wherein higher weighting coefficients are determined when the user equipment has poorer channels;

weighting circuitry for weighting said codeword with said selected weighting coefficient; and
output circuitry for transmitting said weighted encoded signal to said network node.

5.  A method performed at a network node comprising:

    determining a channel quality of each of a plurality of user equipments; and
    determining a weighting coefficient for each of said plurality of user equipments in dependence on said determined channel quality, wherein each weighting coefficient being formed as a product of a plurality of distinct primes, each weighting coefficient excluding a different distinct prime from said product, and wherein user equipments having poorer channels being provided with higher weighting coefficients;
    transmitting an indicator indicative of said determined weighting coefficients to each of said plurality of user equipments, each of said indicators being indicative of a different weighting coefficient;
    receiving a signal comprising a plurality of lattice coded signals each weighted by said respective weighting coefficient from said plurality of user equipments;
    extracting at least one of said user equipment signals by performing a modulo lattice operation on said received signal; and
    decoding said extracted signal.

6.  A method performed at a network node according to claim 5, comprising:
    determining a modulo lattice operation to perform in order to extract each user equipment signal in dependence upon said weighting coefficient.

7.  A method performed at a network node according to any one of claims 5 to 6, comprising an initial step of scaling said received signal by a scale factor, said scale factor being selected so as to reduce noise by approximating said scaled weighting coefficients to integers and rounding said channels embedded in said signal into integers or complex integers where each rounded integer is relatively prime to a distinct prime excluded from said corresponding weighting coefficient product.

8.  A method performed at a network node according to any one of claims 5 to 7, comprising:

    extracting a plurality of said user equipment signals by performing a plurality of modulo lattice operations on said received signal; and
    decoding said extracted signals.

9.  A method performed at a network node according to claim 8, comprising performing at least some of said plurality of modulo lattice operations on said received signal in parallel.

10. A method performed at a network node according to claim 8, comprising performing at least some of said plurality of modulo lattice operations on said received signal in series; wherein
    prior to performing a subsequent modulo lattice operation in said series of modulo lattice operations, performing the steps of:

    reconstructing a weighted lattice coded signal from a previously extracted decoded signal;
    subtracting said reconstructed signal from said received signal to form a resultant signal;
    performing said subsequent modulo lattice operation on said resultant signal to extract a further weighted lattice coded signal; and
    decoding said extracted signal.

11. A method performed at a network node according to claim 10, comprising performing said modulo lattice operations in series in an order that is dependent on said channel quality, said modulo lattice operation being performed on signals being transmitted on a poorer channel earlier than on signals transmitted on a stronger channel.

12. A network node comprising:

    determining circuitry operable to determine a channel quality of each of a plurality of user equipments and to determine a weighting coefficient for each of said plurality of user equipments in dependence on said determined channel quality, wherein each weighting coefficient being formed as a product of a plurality of distinct primes, each weighting coefficient excluding a different distinct prime from said product, and wherein user equipments having poorer channels being provided with higher weighting coefficients;
a transmitter operable to transmit an indicator indicative of said determined weighting coefficients to each of said plurality of user equipments, each of said indicators being indicative of a different weighting coefficient;
a receiver for receiving a signal comprising a plurality of lattice coded signals each weighted by a respective weighting coefficient from said plurality of user equipments;
a signal extractor for extracting at least one of said user equipment signals by performing a modulo lattice operation on said received signal; and
a decoder for decoding said extracted signal.

13. A computer program which when executed by a computer is operable to control said computer to performs steps in a method according to any one of claims 1 to 3 and 5 to 11.

**Patentansprüche**

1.  An einer Teilnehmereinrichtung durchgeführtes Verfahren, das Folgendes umfasst:

    Empfangen einer Anzeige eines Gewichtungskoeffizienten von einem Netzwerkknoten, wobei die Anzeige eine relative Anzeige umfasst, die eine Kanalqualität der Teilnehmereinrichtung im Vergleich zu einer Kanalqualität anderer Teilnehmereinrichtungen, die mit dem Netzwerkknoten kommunizieren, anzeigt;
    Auswählen eines Gewichtungskoeffizienten aus einer Vielzahl von gespeicherten Gewichtungskoeffizienten, um ein Codewort eines Gittercodes zu gewichten, wobei die Vielzahl von gespeicherten Gewichtungskoeffizienten jeweils als ein Produkt eindeutiger Primzahlen gebildet wird, wobei jeder Gewichtungskoeffizient durch Ausschließen einer anderen eindeutigen Primzahl aus dem Produkt gebildet wird, wobei der Gewichtungskoeffizient in Abhängigkeit von der empfangenen Anzeige ausgewählt wird, derart, dass der Teilnehmereinrichtung, wenn sie schlechtere Kanäle aufweist, höhere Gewichtungskoeffizienten bereitgestellt werden;
    lineares Codieren eines Signals zur Übertragung zum Netzwerkknoten;
    Zuordnen des linear codierten Signals, um einen Gittercode zu bilden;
    Gewichten des Codeworts des Gittercodes mit dem ausgewählten Gewichtungskoeffizienten und
    Übertragen des gewichteten codierten Signals zum Netzwerkknoten.

2.  An einer Teilnehmereinrichtung durchgeführtes Verfahren nach Anspruch 1, wobei der Schritt des linearen Codierens das Erzeugen eines linearen Codes über einem finiten Feld umfasst.

3.  An einer Teilnehmereinrichtung durchgeführtes Verfahren nach Anspruch 2, wobei eine Größe des finiten Feldes mit einer Größe des Gewichtungskoeffizienten verknüpft ist, wobei ein höherer Gewichtungskoeffizient ein kleineres finites Feld anzeigt.

4.  Teilnehmereinrichtung, die Folgendes umfasst:

    einen Empfänger zum Empfangen einer Anzeige eines Gewichtungskoeffizienten von einem Netzwerkknoten, wobei die Anzeige eine relative Anzeige umfasst, die eine Kanalqualität der Teilnehmereinrichtung im Vergleich zu einer Kanalqualität anderer Teilnehmereinrichtungen, die mit dem Netzwerkknoten kommunizieren, anzeigt;
    einen linearen Codierer zum Codieren eines Signals zur Übertragung zu einem Netzwerkknoten;
    eine Zuordnungsschaltung, die dazu ausgelegt ist, das linear codierte Signal zu codieren, um einen Gittercode zu bilden;
    einen Datenspeicher zum Speichern einer Vielzahl von Gewichtungskoeffizienten, wobei die Vielzahl von Gewichtungskoeffizienten jeweils als ein Produkt eindeutiger Primzahlen gebildet wird, wobei jeder Gewichtungskoeffizient durch Ausschließen einer anderen eindeutigen Primzahl aus dem Produkt gebildet wird;
    eine Bestimmungsschaltung, die betreibbar ist, einen der Vielzahl von Gewichtungskoeffizienten aus den gespeicherten Gewichtungskoeffizienten auszuwählen, um ein Codewort des Gittercodes in Abhängigkeit von der empfangenen Anzeige zu gewichten, wobei höhere Gewichtungskoeffizienten bestimmt werden, wenn die Teilnehmereinrichtung schlechtere Kanäle aufweist;
    eine Gewichtungsschaltung zum Gewichten des Codeworts mit dem ausgewählten Gewichtungskoeffizienten und
    eine Ausgangsschaltung zum Übertragen des gewichteten codierten Signals zum Netzwerkknoten.

5.  An einem Netzwerkknoten durchgeführtes Verfahren, das Folgendes umfasst:

Bestimmen einer Kanalqualität jeder einer Vielzahl von Teilnehmereinrichtungen und

Bestimmen eines Gewichtungskoeffizienten für jede der Vielzahl von Teilnehmereinrichtungen in Abhängigkeit von der bestimmten Kanalqualität, wobei jeder Gewichtungskoeffizient als Produkt einer Vielzahl von eindeutigen Primzahlen gebildet wird, wobei jeder Gewichtungskoeffizient eine andere eindeutige Primzahl aus dem Produkt ausschließt und wobei Teilnehmereinrichtungen mit schlechteren Kanälen höhere Gewichtungskoeffizienten bereitgestellt werden;

Übertragen eines Indikators, der die bestimmten Gewichtungskoeffizienten anzeigt, zu jeder der Vielzahl von Teilnehmereinrichtungen, wobei jeder der Indikatoren einen anderen Gewichtungskoeffizienten anzeigt;

Empfangen eines Signals, das eine Vielzahl von gittercodierten Signalen umfasst, die jeweils durch den jeweiligen Gewichtungskoeffizienten von der Vielzahl von Teilnehmereinrichtungen gewichtet wurden;

Extrahieren von mindestens einem der Teilnehmereinrichtungssignale durch Durchführen einer Modulogitteroperation am empfangenen Signal und Decodieren des extrahierten Signals.

**6.** An einem Netzwerkknoten durchgeführtes Verfahren nach Anspruch 5, das Folgendes umfasst:
Bestimmen einer durchzuführenden Modulogitteroperation, um jedes Teilnehmereinrichtungssignal in Abhängigkeit vom Gewichtungskoeffizienten zu extrahieren.

**7.** An einem Netzwerkknoten durchgeführtes Verfahren nach einem der Ansprüche 5 bis 6, das einen ersten Schritt des Skalierens des empfangenen Signals mit einem Skalierungsfaktor umfasst, wobei der Skalierungsfaktor ausgewählt wird, um durch Approximieren der skalierten Gewichtungskoeffizienten auf Ganzzahlen und Runden der Kanäle, die in dem Signal eingebettet sind, auf Ganzzahlen oder komplexe Ganzzahlen ein Rauschen zu reduzieren, wo jede gerundete Ganzzahl zu einer eindeutigen Primzahl, die aus dem entsprechenden Gewichtungskoeffizientenprodukt ausgeschlossen ist, relativ prim ist.

**8.** An einem Netzwerkknoten durchgeführtes Verfahren nach einem der Ansprüche 5 bis 7, das Folgendes umfasst:

Extrahieren einer Vielzahl der Teilnehmereinrichtungssignale durch Durchführen einer Vielzahl von Modulogitteroperationen am empfangenen Signal und
Decodieren der extrahierten Signale.

**9.** An einem Netzwerkknoten durchgeführtes Verfahren nach Anspruch 8, das das parallele Durchführen von mindestens einigen der Vielzahl von Modulogitteroperationen am empfangenen Signal umfasst.

**10.** An einem Netzwerkknoten durchgeführtes Verfahren nach Anspruch 8, das das Durchführen von mindestens einigen der Vielzahl von Modulogitteroperationen am empfangenen Signal in Reihe umfasst; wobei
vor dem Durchführen einer nachfolgenden Modulogitteroperation in der Reihe von Modulogitteroperationen Durchführen der folgenden Schritte:

Rekonstruieren eines gewichteten gittercodierten Signals aus einem zuvor extrahierten decodierten Signal;
Subtrahieren des rekonstruierten Signals vom empfangenen Signal, um ein resultierendes Signal zu bilden;
Durchführen einer nachfolgenden Modulogitteroperation am resultierenden Signal, um ein weiteres gewichtetes gittercodiertes Signal zu extrahieren; und
Decodieren des extrahierten Signals.

**11.** An einem Netzwerkknoten durchgeführtes Verfahren nach Anspruch 10, das das Durchführen der Modulogitteroperationen in Reihe in einer Reihenfolge umfasst, die von der Kanalqualität abhängig ist, wobei die Modulogitteroperation an Signalen, die auf einem schlechteren Kanal übertragen werden, früher durchgeführt wird als an Signalen, die auf einem stärkeren Kanal übertragen werden.

**12.** Netzwerkknoten, der Folgendes umfasst:

eine Bestimmungsschaltung, die betreibbar ist, eine Kanalqualität jeder der Vielzahl von Teilnehmereinrichtungen zu bestimmen und einen Gewichtungskoeffizienten für jede der Vielzahl von Teilnehmereinrichtungen in Abhängigkeit von der bestimmten Kanalqualität zu bestimmen, wobei jeder Gewichtungskoeffizient als Produkt einer Vielzahl von eindeutigen Primzahlen gebildet wird, wobei jeder Gewichtungskoeffizient eine andere eindeutige Primzahl aus dem Produkt ausschließt und wobei Teilnehmereinrichtungen mit schlechteren Kanälen höhere Gewichtungskoeffizienten bereitgestellt werden;
einen Sender, der betreibbar ist, einen Indikator, der die bestimmten Gewichtungskoeffizienten anzeigt, zu jeder der Vielzahl von Teilnehmereinrichtungen zu übertragen, wobei jeder der Indikatoren einen anderen Gewichtungskoeffizienten anzeigt;

einen Empfänger zum Empfangen eines Signals, das eine Vielzahl von gittercodierten Signalen umfasst, die jeweils durch einen jeweiligen Gewichtungskoeffizienten von der Vielzahl von Teilnehmereinrichtungen gewichtet wurden;

einen Signalextrahierer zum Extrahieren von mindestens einem der Teilnehmereinrichtungssignale durch Durchführen einer Modulogitteroperation am empfangenen Signal und

einen Decodierer zum Decodieren des extrahierten Signals.

13. Computerprogramm, das, wenn es von einem Computer ausgeführt wird, betreibbar ist, den Computer zu steuern, um Schritte in einem Verfahren nach einem der Ansprüche 1 bis 3 und 5 bis 11 durchzuführen.

## Revendications

1. Procédé, mis en oeuvre au niveau d'un équipement utilisateur, comprenant :

la réception d'une indication d'un coefficient de pondération en provenance d'un noeud de réseau, ladite indication comprenant une indication relative indiquant une qualité de canal dudit équipement utilisateur par rapport à une qualité de canal d'autres équipements utilisateurs communiquant avec ledit noeud de réseau ;
la sélection d'un coefficient de pondération parmi une pluralité de coefficients de pondération stockés dans le but de pondérer un mot de code d'un code en réseau de points, ladite pluralité de coefficients de pondération stockés étant chacun formés comme un produit de nombres premiers distincts, chaque coefficient de pondération étant formé par exclusion d'un nombre premier distinct différent dudit produit, le coefficient de pondération étant sélectionné en fonction de ladite indication reçue de façon à doter l'équipement utilisateur de coefficients de pondération plus élevés lorsqu'il présente des canaux de moins bonne qualité ;
le codage linéaire d'un signal en vue de sa transmission audit noeud de réseau ;
le mappage dudit signal codé linéairement afin de former un code en réseau de points ;
la pondération dudit mot de code dudit code en réseau de points par ledit coefficient de pondération sélectionné ; et
la transmission dudit signal codé pondéré audit noeud de réseau.

2. Procédé, mis en oeuvre au niveau d'un équipement utilisateur, selon la revendication 1, dans lequel ladite étape de codage linéaire comprend la génération d'un code linéaire sur un champ fini.

3. Procédé, mis en oeuvre au niveau d'un équipement utilisateur, selon la revendication 2, dans lequel une taille dudit champ fini est liée à une taille dudit coefficient de pondération, un coefficient de pondération plus élevé indiquant un champ fini plus petit.

4. Équipement utilisateur, comprenant :

un récepteur destiné à recevoir une indication d'un coefficient de pondération en provenance d'un noeud de réseau, ladite indication comprenant une indication relative indiquant une qualité de canal dudit équipement utilisateur par rapport à une qualité de canal d'autres équipements utilisateurs communiquant avec ledit noeud de réseau ;
un codeur linéaire destiné à coder un signal en vue de sa transmission à un noeud de réseau ;
des circuits de mappage configurés pour mapper ledit signal codé linéairement afin de former un code en réseau de points ;
une unité de stockage de données destinée à stocker une pluralité de coefficients de pondération, ladite pluralité de coefficients de pondération étant chacun formés comme un produit de nombres premiers distincts, chaque coefficient de pondération étant formé par exclusion d'un nombre premier distinct différent dudit produit ;
des circuits de détermination utilisables pour sélectionner l'un de ladite pluralité de coefficients de pondération parmi lesdits coefficients de pondération stockés afin de pondérer un mot de code dudit code en réseau de points en fonction de ladite indication reçue, des coefficients de pondération plus élevés étant déterminés lorsque l'équipement utilisateur présente des canaux de moins bonne qualité ;
des circuits de pondération destinés à pondérer ledit mot de code par ledit coefficient de pondération sélectionné ; et
des circuits de sortie destinés à transmettre ledit signal codé pondéré audit noeud de réseau.

**5.** Procédé, mis en oeuvre au niveau d'un noeud de réseau, comprenant :

la détermination d'une qualité de canal de chacun d'une pluralité d'équipements utilisateurs ; et
la détermination d'un coefficient de pondération pour chacun de ladite pluralité d'équipements utilisateurs en fonction de ladite qualité de canal déterminée, chaque coefficient de pondération étant formé comme un produit d'une pluralité de nombres premiers distincts, chaque coefficient de pondération excluant un nombre premier distinct différent dudit produit, et des équipements utilisateurs présentant des canaux de moins bonne qualité étant dotés de coefficients de pondération plus élevés ;
la transmission d'un indicateur indiquant lesdits coefficients de pondération déterminés à chacun de ladite pluralité d'équipements utilisateurs, chacun desdits indicateurs indiquant un coefficient de pondération différent ;
la réception d'un signal comprenant une pluralité de signaux codés en réseau de points, pondérés chacun par ledit coefficient de pondération respectif, en provenance de ladite pluralité d'équipements utilisateurs ;
l'extraction d'au moins un desdits signaux d'équipement utilisateur par réalisation d'une opération modulo un réseau de points sur ledit signal reçu ; et
le décodage dudit signal extrait.

**6.** Procédé, mis en oeuvre au niveau d'un noeud de réseau, selon la revendication 5, comprenant :
la détermination d'une opération modulo un réseau de points à réaliser pour extraire chaque signal d'équipement utilisateur en fonction dudit coefficient de pondération.

**7.** Procédé, mis en oeuvre au niveau d'un noeud de réseau, selon l'une quelconque des revendications 5 à 6, comprenant une étape initiale de mise à l'échelle dudit signal reçu par un facteur d'échelle, ledit facteur d'échelle étant sélectionné de manière à réduire le bruit par approximation desdits coefficients de pondérations mis à l'échelle par des entiers et arrondi desdits canaux incorporés dans ledit signal en entiers ou entiers complexes, chaque entier arrondi consistant en un nombre relativement premier avec un nombre premier distinct exclu dudit produit de coefficient de pondération correspondant.

**8.** Procédé, mis en oeuvre au niveau d'un noeud de réseau, selon l'une quelconque des revendications 5 à 7, comprenant :

l'extraction d'une pluralité desdits signaux d'équipement utilisateur par réalisation d'une pluralité d'opérations modulo un réseau de points sur ledit signal reçu ; et
le décodage desdits signaux extraits.

**9.** Procédé, mis en oeuvre au niveau d'un noeud de réseau, selon la revendication 8, comprenant la réalisation en parallèle d'au moins certaines de ladite pluralité d'opérations modulo un réseau de points sur ledit signal reçu.

**10.** Procédé, mis en oeuvre au niveau d'un noeud de réseau, selon la revendication 8, comprenant la réalisation en série d'au moins certaines de ladite pluralité d'opérations modulo un réseau de points sur ledit signal reçu ;
préalablement à la réalisation d'une opération modulo un réseau de points suivante dans ladite série d'opérations modulo un réseau de points, la réalisation des étapes suivantes :

la reconstruction d'un signal codé en réseau de points pondéré à partir d'un signal décodé précédemment extrait ;
la soustraction dudit signal reconstruit audit signal reçu afin de former un signal résultant ;
la réalisation de ladite opération modulo un réseau de points suivante sur ledit signal résultant afin d'extraire un signal codé en réseau de points pondéré supplémentaire ; et
le décodage dudit signal extrait.

**11.** Procédé, mis en oeuvre au niveau d'un noeud de réseau, selon la revendication 10, comprenant la réalisation en série desdites opérations modulo un réseau de points dans un ordre qui est fonction de ladite qualité de canal, ladite opération modulo un réseau de points étant réalisée sur des signaux transmis sur un canal de moins bonne qualité plus tôt que sur des signaux transmis sur un canal de meilleure qualité.

**12.** Noeud de réseau, comprenant :

des circuits de détermination utilisables pour déterminer une qualité de canal de chacun d'une pluralité d'équipements utilisateurs et pour déterminer un coefficient de pondération pour chacun de ladite pluralité d'équipements utilisateurs en fonction de ladite qualité de canal déterminée, chaque coefficient de pondération étant formé comme un produit d'une pluralité de nombres premiers distincts, chaque coefficient de pondération excluant un nombre premier distinct différent dudit produit, et des équipements utilisateurs présentant des canaux de moins bonne qualité étant dotés de coefficients de pondération plus élevés ;

un émetteur utilisable pour transmettre un indicateur indiquant lesdits coefficients de pondération déterminés à chacun de ladite pluralité d'équipements utilisateurs, chacun desdits indicateurs indiquant un coefficient de pondération différent ;

un récepteur destiné à recevoir un signal comprenant une pluralité de signaux codés en réseau de points, pondérés chacun par un coefficient de pondération respectif, en provenance de ladite pluralité d'équipements utilisateurs ;

un extracteur de signal destiné à extraire au moins un desdits signaux d'équipement utilisateur en réalisant une opération modulo un réseau de points sur ledit signal reçu ; et

un décodeur destiné à décoder ledit dudit signal extrait.

13. Programme d'ordinateur qui, lorsqu'il est exécuté par un ordinateur, est utilisable pour commander audit ordinateur de réaliser des étapes dans un procédé selon l'une quelconque des revendications 1 à 3 et 5 à 11.

Performance comparison between the proposed NOMA and the conventional OMA

FIG. 1

Schematic illustration of the proposed uplink-LPMA with MLO-SIC.

FIG. 2

EP 3 206 318 B1

Schematic illustration of the proposed uplink-LPMA with MLO-PIC.

FIG. 3

Schematic illustration of coding and modulation procedure at user equipment

FIG. 4

Schematic illustration of SIC decoding at BS.

FIG. 5

Schematic illustration of PIC decoding at BS.

FIG. 6

Receive network coefficient indication

Determine encoder and coefficients for UE

Encode and map encoded signal to form a lattice code, weight the lattice code, normalise encoded signal and output

FIG. 7

Determine channel quality of multiple UEs

Transmit indicator indicating weighting coefficient to each UE

Receive NOMA signal from multiple UEs

Perform signal extraction in parallel? — No

Yes

Route signal to multiple signal extractors and decoders

Perform modulo lattice operation relevant to weighting coefficient at each signal extractor to extract signal

Decode and output each extracted UE signal

End

Route signal to first signal extractor and decoder

Perform modulo lattice operation on signal and extract UE signal with highest weighting coefficient on received signal

Decode signal

Reconstruct lattice code for signal

Subtract from signal input to modulo lattice operation to generate resultant signal

Output decoded signal

All signals extracted? — Yes

No

Route resultant signal to next signal extractor and decoder

End

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **NATARAJAN et al.** Lattice Index Coding. *IEEE Transactions on Information Theory,* December 2015, vol. 61 (12

- **YU-CHIH HUANG et al.** *Multistage Compute-and Forward with Multilevel Lattice Codes Based on Product Constructions*